(19) 

Europäisches
Patentamt
European
Patent Office
Office européen
des brevets

(11) **EP 4 756 726 A1**

(12) **EUROPEAN PATENT APPLICATION**
published in accordance with Art. 153(4) EPC

(43) Date of publication:
**10.06.2026 Bulletin 2026/24**

(21) Application number: **24852369.8**

(22) Date of filing: **08.08.2024**

(51) International Patent Classification (IPC):
*G06T 19/20* (2011.01)    *G06Q 30/06* (2023.01)
*G06F 3/04845* (2022.01)    *G06T 17/00* (2006.01)
*G06T 15/04* (2011.01)

(52) Cooperative Patent Classification (CPC):
**G06T 19/20; G06F 3/04845; G06Q 30/06;**
**G06T 15/04; G06T 17/00;** G06T 2200/24;
G06T 2210/16; G06T 2219/2016; G06T 2219/2021

(86) International application number:
**PCT/KR2024/011793**

(87) International publication number:
**WO 2025/034016 (13.02.2025 Gazette 2025/07)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **08.08.2023 KR 20230103790**
**07.08.2024 KR 20240105641**

(71) Applicant: **CLO Virtual Fashion Inc.**
**Seoul 06236 (KR)**

(72) Inventor: **GEORG, Sperl**
**2361 Laxenburg (AT)**

(74) Representative: **V.O.**
**P.O. Box 87930**
**2508 DH Den Haag (NL)**

(54) **METHOD FOR SIMULATING CLOTHING AND DEVICE THEREFOR**

(57)    The disclosure below relates to a method for simulating clothing, which may comprise the operations of: receiving a selection input for one or more points or areas of clothing through a user interface; determining one or more activation areas within a preset distance from the selected one or more points or areas; receiving a movement or displacement on the basis of the selected one or more points or areas; transforming one or more activation areas in response to the received movement or displacement; interpolating a transformation corresponding to the movement or displacement according to a distance from the selected one or more points or areas in an intermediate area within the one or more activation areas; and in a state in which the selected one or more points or areas are transformed and a state in which a simulation area outside the one or more activation areas is simulated, displaying the intermediate area in an interpolated state.

Start

Receive selection input for one or more points or areas of clothing through user interface ⌐110

Determine one or more activation areas within preset distance from one or more selected points or areas ⌐120

Receive movement or displacement based on one or more selected points or areas ⌐130

Deform one or more activation areas in response to received movement or displacement ⌐140

Interpolate deformation corresponding to movement or displacement based on distance from one or more selected points or areas in intermediate area within one or more activation areas ⌐150

Display intermediate area in interpolated state while one or more selected points or areas are in deformed state, and external simulation area is in simulated state ⌐160

End

**FIG. 1**

## Description

### TECHNICAL FIELD

The following embodiments relate to a method and device for simulating clothing.

### BACKGROUND ART

Clothing simulation technology may play a significant role in the 3D graphics field. Clothing simulation technology may be used in various fields, such as the game industry or fashion design. Clothing simulation may allow a user to design clothing or modify the design in a virtual environment and visualize the clothing before production. With the recent advancement of physics-based simulation, realistic motion and deformation of clothing may be more accurately represented. Physics-based simulation may enable a more natural simulation considering gravity, friction, collision, or the like by using the material properties and physical properties of clothing. Accordingly, the user may experience further realistic clothing design and visualization.

### DISCLOSURE OF THE INVENTION

### TECHNICAL SOLUTIONS

According to an embodiment, a clothing simulation method include receiving an input to select one or more points or areas of clothing through a user interface, determining one or more activation areas within a preset distance from the selected one or more points or areas, receiving motion or displacement based on the selected one or more points or areas, deforming the one or more activation areas corresponding to the received motion or displacement, interpolating a deformation corresponding to the motion or displacement depending on a distance from the selected one or more points or areas in an intermediate area within the one or more activation areas, and displaying the intermediate area in an interpolated state while the selected one or more points or areas are deformed and a simulation area outside the one or more activation areas is simulated.

The one or more activation areas may be areas that are influenced by motion or displacement of the selected one or more points or areas.

The motion may include at least one of rotation, translation, scaling, or twisting.

The simulation area outside the one or more activation areas may be an area that is minimally or not influenced by the motion or displacement of the selected one or more points or areas.

The preset distance may include Euclidean distance or geodesic distance, and the determining of the one or more activation areas may include calculating a weight based on the Euclidean distance or the geodesic distance.

The calculating of the weight may include calculating a weight distribution based on a function received through the user interface.

The determining of the one or more activation areas may include performing smoothing or weight painting using a bitmap-based brush or stamp.

The determining of the one or more activation areas may include post-processing the weight based on at least one of normalization, smoothing, or limiting a specific part of the garment, a mesh, or a pattern.

The receiving of the motion or displacement based on the selected one or more points or areas may include sensing user input using a pinching interface, which is applied to a weight-applied area.

The receiving of the motion or displacement based on the selected one or more points or areas may include sensing user input using a gizmo interface, which is applied to the one or more selected areas.

The interpolating may include performing a weighted average on the degree of deformation of the intermediate area, based on a mesh deformation of the selected one or more points or areas. The weight in the intermediate area may be adjusted to a value between 0 and 1 based on a weight function.

According to an embodiment, an electronic device includes memory storing instructions, an output interface displaying a user interface, and one or more processors, in which the instructions, when performed by the one or more processors, cause the electronic device to receive an input to select one or more points or areas of clothing through a user interface, determine one or more activation areas within a preset distance from the selected one or more points or areas, receive motion or displacement based on the selected one or more points or areas, deform the one or more activation areas corresponding to the received motion or displacement, interpolate a deformation corresponding to the motion or displacement depending on a distance from the selected one or more points or areas in an intermediate area within the one or more activation areas, and display the intermediate area in an interpolated state while the selected one or more points or areas are deformed and a simulation area outside the one or more activation areas is simulated.

**BRIEF DESCRIPTION OF DRAWINGS**

FIG. 1 is a flowchart illustrating a clothing simulation method according to an embodiment.

FIG. 2 is a diagram schematically illustrating an area adjustment interface according to an embodiment.

FIGS. 3A and 3B are diagrams, each schematically illustrating an activated state of soft selection according to an embodiment.

FIGS. 4A and 4B are diagrams, each schematically illustrating deformations of soft selection activation area according to falloff distance adjustment, according to an embodiment.

FIGS. 5A to 5E are diagrams, each schematically illustrating deformations of soft selection activation area according to falloff power adjustment, according to an embodiment.

FIGS. 6A to 6E are diagrams, each schematically illustrating a weight distribution deformation according to adjustment of a falloff kernel menu, according to an embodiment.

FIG. 7 is a diagram schematically illustrating Euclidean distance and geodesic distance according to an embodiment.

FIG. 8 is a diagram schematically illustrating geodesic distance-based soft selection according to an embodiment.

FIG. 9 is a diagram schematically illustrating multi-soft selection according to an embodiment.

FIGS. 10A to 10C are diagrams, each illustrating operation of a gizmo interface according to an embodiment.

FIG. 11 is a diagram schematically illustrating a pinching interface according to an embodiment.

FIG. 12A and 12B are diagrams, each schematically illustrating a pinching interface according to an embodiment.

FIG. 13 is a block diagram illustrating an electronic device according to an embodiment.

**BEST MODE FOR CARRYING OUT THE INVENTION**

The following detailed structural or functional description is provided as an example only and various alterations and modifications may be made to the examples. Here, examples are not construed as limited to the disclosure and should be understood to include all changes, equivalents, and replacements within the idea and the technical scope of the disclosure.

Terms, such as first, second, and the like, may be used herein to describe various components. Each of these terminologies is not used to define an essence, order or sequence of a corresponding component but used merely to distinguish the corresponding component from other component(s). For example, a first component may be referred to as a second component, and similarly the second component may also be referred to as the first component.

It should be noted that if it is described that one component is "connected", "coupled", or "joined" to another component, a third component may be "connected", "coupled", and "joined" between the first and second components, although the first component may be directly connected, coupled, or joined to the second component.

The singular forms "a", "an", and "the" are intended to include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof.

As used herein, "A or B," "at least one of A and B," "at least one of A or B," "A, B or C," "at least one of A, B and C," and "at least one of A, B, or C," each of which may include any one of the items listed together in the corresponding one of the phrases, or all possible combinations thereof.

Unless otherwise defined, all terms, including technical and scientific terms, used herein have the same meaning as commonly understood by one of ordinary skill in the art to which the present disclosure pertains. Terms, such as those defined in commonly used dictionaries, are to be interpreted as having a meaning that is consistent with their meaning in the context of the relevant art and are not to be interpreted in an idealized or overly formal sense unless expressly so defined herein.

Hereinafter, embodiments will be described in detail with reference to the accompanying drawings. When describing the examples with reference to the accompanying drawings, like reference numerals refer to like components and a repeated description related thereto will be omitted.

In a clothing simulation method, using a physics simulation may enable a more natural simulation by using the materials and properties of clothing and user input or an external force from the environment. For example, a vertex-based deformation method among physics simulation methods may deform clothing in such a manner that a user selects a specific vertex on a mesh surface and, by translating this vertex, obtains the displacement of the translated vertex by taking into account the materials and properties of the clothing, as well as user input or an external force from the environment.

However, this physics simulation may also be limited in providing a user-friendly interface and intuitive manipulation methods. Specifically, when clothing is complex or includes a plurality of patterns, a natural simulation may not be readily achieved.

To address such issues, soft selection is described as the clothing simulation method in the embodiments described below.

Soft selection may define a selected area around a point or area specified by the user and enable the selected area to be naturally deformed based on the user's manipulation. Soft selection may cause a more intuitive clothing simulation compared to a previous vertex-based clothing simulation method and control a complex deformation of clothing.

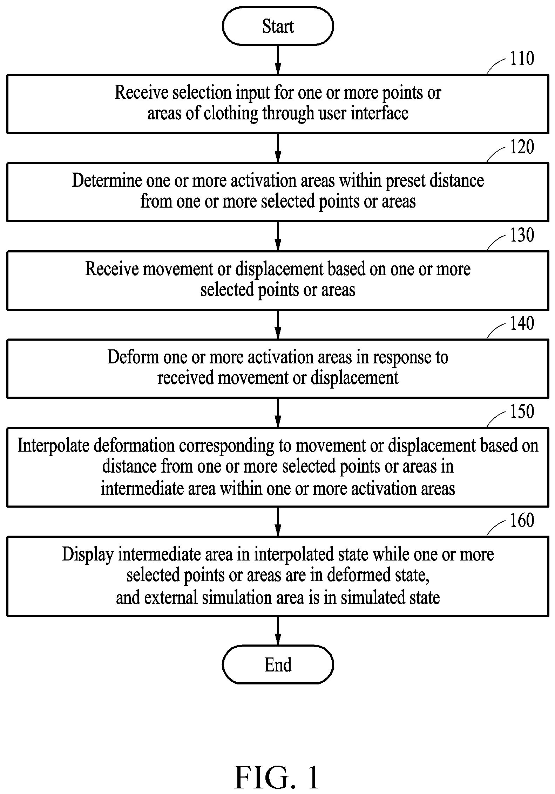

FIG. 1 is a flowchart illustrating a clothing simulation method according to an embodiment.

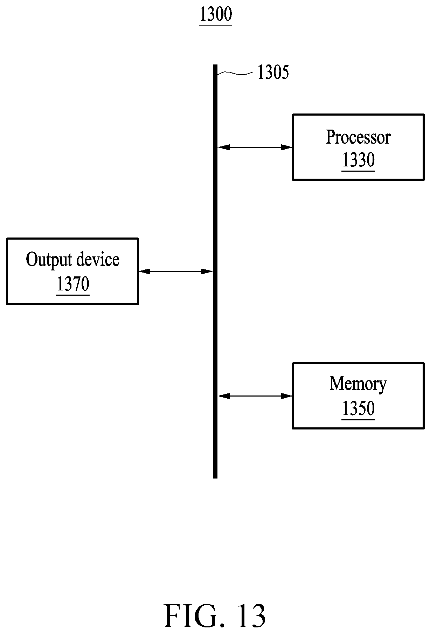

For ease of description, operations 110 to 170 are described as being performed by using an electronic device 1300 illustrated in FIG. 13. However, operations 110 to 170 may be performed by another suitable electronic device in a suitable system.

Although the operations of FIG. 1 may be performed in the illustrated order and manner therein, the order of some of the operations may change or some of the operations may be omitted, without departing from the spirit and scope of the illustrated example. The operations illustrated in FIG. 1 may be performed in parallel or simultaneously.

In operation 110, the electronic device 1300 may receive an input to select one or more points or areas of clothing through a user interface. A user may select a point or an area by touching or clicking on a specific part of the clothing displayed on the user interface by using a touch screen or a mouse cursor. For example, when the user clicks on a sleeve part of the clothing through the touch screen, a corresponding point may be selected, and the electronic device 1300 may receive the selected point.

In operation 120, the electronic device 1300 may determine one or more activation areas within a preset distance from one or more selected points or areas. The preset distance may be either Euclidean distance or geodesic distance. The one or more activation areas may be areas influenced by motion or displacement of a point or an area. The motion may include at least one of rotation, translation, scaling, or twisting. For example, when the user selects a sleeve part, an activation area within a preset distance from the selected point in the sleeve part may be determined automatically.

According to an embodiment, the electronic device 1300 may calculate a weight based on Euclidean distance or geodesic distance. The electronic device 1300 may calculate a weight distribution based on a function received through the user interface. For example, when the user selects a function, such as a linear function, a hat function, a bump function, or a sinusoidal function, in the user interface, the electronic device 1300 may calculate the weight distribution based on the received function.

According to an embodiment, the electronic device 1300 may generate another weight distribution in addition to the weight distribution generated through preset functions as described above. For example, when the user inputs any shape (e.g., a pattern with complex unevenness) desired by the user through the user interface, the electronic device 1300 may calculate the weight distribution by functionalizing the input shape. The electronic device 1300 may calculate the weight distribution based on the preset functions in memory 1350 or by mapping the preset functions like the shape desired by the user. For example, the electronic device 1300 may calculate the weight distribution through a new function by loading, from the memory 1350, and mapping a preset function whose basic form is similar to a shape (e.g., a shape including many sharp uneven parts outside a circular line) desired by the user and deforming the preset function to fit the shape desired by the user.

Weight may be a value that indicates how much deformation influences depending on a distance from a selected point or area when clothing is deformed in an activation area. For example, a weighted numerical value may change as the user gets farther away from the selected point. When the user selects and drags an end of a sleeve through the touch screen to pick up the sleeve, a part closer to the sleeve end may deform more, and a shoulder part may deform less. For another example, when the user picks up a waist area, the waist area may deform more, and an upper torso area and a lower skirt area may deform less.

Euclidean distance may refer to a straight-line distance between two points. Euclidean distance is a method of calculating a distance and may be used to determine the distance between two points on a plane or in three-dimensional (3D) space. When one or more activation areas are determined based on the Euclidean distance, a pattern belonging to another piece of clothing or another layer may be included in the activation area, in addition to a pattern or layer that includes the one or more selected points or areas.

Geodesic distance may refer to a distance from a mesh surface of clothing. Geodesic distance may be used to determine a distance on a curved or complex surface. Geodesic distance may be a manner for determining a distance along the curved surface of such a 3D structure as clothing. When one or more activation areas are determined based on the geodesic distance, since a distance is determined along a mesh surface of a pattern or a layer that includes one or more selected points or areas, the activation areas may be determined within the pattern or the layer including the one or more selected points or areas or may be determined by extending to adjacent patterns or layers. As described below, in the embodiments described below, when the user selects a waist part of the clothing, the electronic device 1300 may use geodesic distance measurement method so that an activation area may be set along a mesh surface on the user interface.

A linear function may refer to a function in which a weight decreases linearly depending on a distance from a selected point. When the linear function is applied to a weight distribution, a weight decreases at a constant rate as it gets farther away from the selected point so that the weight may be distributed to decrease evenly.

A hat function is a conical function, and when the hat function is applied to a weight distribution, a weight may decrease linearly as it gets farther from the center. For example, when the weight is calculated by using the hat function for a sleeve end, the weight distribution may be generated, causing the weight to decrease linearly from the sleeve end to the shoulder.

The bump function is a Gaussian-shaped function, and when the bump function is applied to a weight distribution, a weight may decrease exponentially as it gets farther away from the center. For example, when the weight is calculated by using the bump function for a waist, the weight distribution may be generated, causing the weight to decrease exponentially as it gets farther away from the waist.

The sinusoid function is a function in the form of a sine function, and when the sinusoid function is applied to a weight distribution, a weight may fluctuate in a periodic pattern. For example, when the electronic device 1300 expresses a wrinkle, when the sinusoid function is used to generate periodic weight fluctuation, the wrinkle may be generated naturally.

According to an embodiment, the electronic device 1300, when determining one or more activation areas, may perform weighted painting using smoothing or a bitmap-based brush.

Smoothing may refer to smoothing out a change in a weight or a change in a mesh so that a smooth surface may be generated after clothing is deformed. For example, the electronic device 1300 may perform smoothing after deforming a sleeve end so that a natural wrinkle may be generated. The electronic device 1300 may smoothly change the weight by averaging adjacent weight values through the smoothing. For example, when the user selects a sleeve of the clothing, deforms an activation area, and applies the smoothing, a sleeve part may deform smoothly and naturally.

A bitmap-based brush or a bitmap-based stamp is a brush or a stamp based on a bitmap image and may be used for weighted painting. The brush or the stamp may be used by the user to apply a preset weight, either increasing or decreasing it. For example, in an activation area, the user may use the brush to paint a weight to emphasize the deformation of a particular part of a specific pattern on clothing.

For example, when the user selects a sleeve pattern of the clothing and performs deformations, enhancing the weight and applying it to a sleeve-folded part by using the brush to emphasize a wrinkled part of a part where the sleeve pattern is deformed, the folded part of the sleeve pattern may deform more clearly.

According to an embodiment, the electronic device 1300 may post-process a weight based on at least one of normalization, smoothing, and limiting operations on a specific part of clothing, a mesh, or a pattern.

Normalization may refer to a process of adjusting a weight value to fall within a certain range. Normalization may be used to prevent a weight value from getting excessively large or small. For example, the electronic device 1300 after applying weights to one or more activation areas, may normalize all weight values to values between 0 and 1.

Smoothing may refer to a process of naturally connecting the deformation of a mesh or a weight. For example, the electronic device 1300 may smooth the weight so that an unnatural wrinkle does not be formed after deforming a sleeve end.

A limiting operation for a specific part of clothing, a mesh, or a pattern may refer to a process of limiting the application of a weight to the specific part. The limiting operation may be used to prevent or limit the deformation of the specific part of clothing. For example, the weight may be limited for a specific pattern part of the clothing to prevent that part from getting deformed. When the electronic device 1300 limits the application of a weight to a waist strap pattern part of the clothing, the waist strap pattern part may remain without being deformed even if a torso pattern is deformed.

In operation 130, the electronic device 1300 may receive motion or displacement for the one or more selected points or areas.

In operation 140, the electronic device 1300 may deform the one or more activation areas in response to the received motion or displacement.

The deformation may mainly refer to a process where a specific part of clothing changes in response to user input. For example, it may refer that, when the user selects and drags a specific point of the clothing, one or more activation areas translate or change their shape.

According to an embodiment, the electronic device 1300 may sense user input by using a pinching interface applied to a weight-applied area. The pinching interface may be an interface that supports the user to perform operations, such as picking up, dragging, or pulling a specific point.

The electronic device 1300 may implement a simulation, such as an 'effect of picking up a specific point with a finger' by translating a specific vertex of clothing or vertices within a certain area based on the user's pinching input. For example, when the user performs the action of picking up a specific point of a sleeve end by using the pinching interface, the electronic device 1300 may detect this input and perform the deformation where the sleeve end rises upward.

According to an embodiment, the electronic device 1300 may detect the user's gizmo input by using a gizmo interface applied to one or more activation areas. The gizmo interface may be an interface that assists the user in performing deformations, such as rotating, translating, and scaling an object in 3D space. For example, when the user performs a rotation operation using the gizmo interface on a waist part of the clothing, the electronic device 1300 may detect this input and perform a deformation that rotates the waist part.

When the user performs a deformation using the pinching interface or the gizmo interface on a specific part of clothing, the electronic device 1300 may sense this in real time and apply the deformation. For example, when the user performs the action of picking up a wrinkled part of clothing with the pinching interface or twisting it with the gizmo interface, the electronic device 1300 may detect this input and naturally deform the wrinkled part.

In operation 150, the electronic device 1300 may interpolate a deformation corresponding to motion or displacement based on a distance from one or more selected points in an intermediate area within the one or more activation areas.

According to an embodiment, the electronic device 1300 may weigh the degree of deformation of an intermediate area based on the deformation of one or more selected points or areas. Weights in the intermediate area may be adjusted to values between 0 and 1 based on a user-selected weighting function. A weighted average may be expressed by Equation 1 below. The electronic device 1300 may perform weighted blending as shown in Equation 1 below to display a simulation result corresponding to a deformation in an activation area by the user.

[Equation 1]

$$(1 - w) \times x_{new} + w \times x_{user} = WB(Weighted\ Blended)$$

In Equation 1, w denotes a weight, and w may be adjusted to a value between 0 and 1. $x_{new}$ denotes a mesh shape after a simulation, and $x_{user}$ denotes a mesh shape that has been deformed by the user's manipulation.

According to an embodiment, the electronic device 1300 may perform an interpolation to provide a natural transition between a selected point (or area) and an external simulation area. The external simulation area may be an area that is minimally or not influenced by the motion or displacement of a point or an area.

For example, when the user deforms a sleeve end, an interpolation may be performed on the deformation in an intermediate area within an activation area so that the sleeve end which is the selected point is naturally connected to a shoulder part which is the external simulation area.

According to embodiments, the electronic device 1300 may identify an intermediate area where an interpolation is performed for a natural transition between a selected point (or area) and an external simulation area. The intermediate area may be included in a corresponding activation area within a preset distance from the selected point. In this case, the electronic device 1300 may identify a clearer intermediate area based on a simulation result regarding the activation area and the external simulation area. Accordingly, the electronic device 1300 may be set to adaptively check the preset distance from the selected point corresponding to the boundary of the activation area and perform an interpolation on the intermediate area. Each point in the intermediate area may be weighted so that the deformation of the selected point is naturally connected to the motion of the external simulation area. In other words, the intermediate area may correspond to an area for performing an interpolation process so that a soft selection effect may be expressed naturally by the electronic device 1300.

According to an embodiment, the electronic device 1300 may perform an interpolation operation for a natural connection between an activation area and an external simulation area. The interpolation operation may be performed from the selected point to the boundary of the activation area. The electronic device 1300 may perform the interpolation operation at the boundary of the activation area so that the activation area is naturally connected to the external simulation area.

In an interpolation operation, the electronic device 1300 may calculate the motion of the intermediate area within the activation area by using the deformation intensity of the selected point and the motion of the external simulation area. For example, when the user pulls hard on a sleeve end and deforms it, simulations in the intermediate area may need to form a slightly steep but natural curve. The external simulation area may be simulated with less influence from deformation or may be expressed in its original form so that overall clothing simulations become natural.

According to an embodiment, the electronic device 1300 may adjust the motion of an intermediate area by using a weight value during an interpolation. For example, a point with a high weight may be greatly influenced by the deformation of a selected point and thus may deform significantly while a point with a low weight may be minimally influenced by the deformation of the selected point and thus may deform less.

During an interpolation process, the electronic device 1300 may perform simulations by also using the physical properties of an intermediate area. For example, an interpolation method in the intermediate area may vary depending on the materials or patterns of clothing. For soft-material clothing, a natural simulation may be implemented by using a curved interpolation, and for hard-material clothing, a realistic simulation may be implemented through a linear interpolation.

Accordingly, the electronic device 1300 may interpolate the intermediate area between the selected point and the external simulation area so that the deformation of the whole clothing may be simulated naturally. For example, even when the user deforms a sleeve end significantly, a shoulder part distant from the selected point may be simulated naturally to provide simulations like a worn appearance.

In operation 160, the electronic device 1300 may display an intermediate area in an interpolated state while one or more selected points or areas are in a deformed state, and an external simulation area is in a simulated state.

According to an embodiment, the electronic device 1300 may display one or more selected points or areas, an external simulation area, and an intermediate area in their respective states on a display. For example, when the user deforms a sleeve end, the sleeve end may be displayed in a deformed state, the external simulation area far from the sleeve end in an undeformed or minimally deformed simulation state, and the intermediate area that transitions between the two in an interpolated simulation state.

According to an embodiment, the electronic device 1300 may reflect a deformation operation input by the user in real time to display one or more activation areas in a deformed and interpolated state. For example, when the user pulls up a sleeve end, the sleeve end may be displayed on the screen in an immediately raised state. The deformed state may be reflected in the form desired by the user.

According to an embodiment, the electronic device 1300 may enable an external simulation area to remain in a state that is minimally or not influenced by a deformation operation. For example, even when a sleeve end is deformed, the external simulation area, such as a shoulder part or a torso part, may remain simulated, providing a natural simulation result.

According to an embodiment, the electronic device 1300 may interpolate motion between one or more selected points or areas and an external simulation area so that the intermediate area is displayed in a naturally connected state. For example, when a sleeve end is deformed, the intermediate area within the activation area may be displayed as a natural transition between a deformed selected point and the external simulation area. Accordingly, the user may check the simulation in which a deformed part is naturally connected to the original state.

According to an embodiment, the electronic device 1300 may simulate the state of each of these areas in real time so that the user may check simulation results of clothing.

In the examples of the embodiments herein, for ease of description, a user-selected point is used as an example, but the user may select an area. For example, when selecting a sleeve end, a part of the sleeve end may be set as an area, and accordingly, the electronic device 1300 may perform the interpolation of an intermediate area and the simulation of an external simulation area according to the deformation of the 'selected area'. In this case, an area (e.g., a circular area) at a certain distance from a user-selected point or an area (e.g., an elliptical area) defined by a certain shape irrespective of the distance may correspond to a user-selected area. A constant distance or a constant shape may be preset by the electronic device 1300 or may be configurable so that the user may customize it.

In the embodiments described, simulation may refer to a concept encompassing the whole clothing simulation process. The simulation may include a representation of how a specific part of the clothing is deformed in response to user input, and how such deformation influences the overall behavior of the clothing. The simulation may refer to the overall motion of the clothing, including the deformation of one or more activation areas and areas outside the one or more activation areas. The electronic device 1300 may simulate how the clothing reacts and deforms based on the user's manipulation by using the physical properties of the clothing through physics simulation. A physics simulation may provide a realistic representation of the behavior of clothing based on its materials or properties and external forces resulting from user input or environmental conditions.

According to an embodiment, the electronic device 1300 may simulate deformation of one or more activation areas depending on weight and an external simulation area, based on the physical properties of fabric applied to clothing. For example, depending on the physical properties, such as material properties, thickness, or length, of the fabric applied to the clothing, interpolations and deformations may vary in one or more activation areas, and simulation in the external simulation areas may also vary. The electronic device 1300 may simulate the appearance of deformed clothing when actually worn. Consequently, the electronic device 1300 may simulate interpolations and deformations in one or more activation areas based on user input of motion or displacement and perform simulations in external simulation areas to reflect various styles and shapes of clothing according to the user's manipulation.

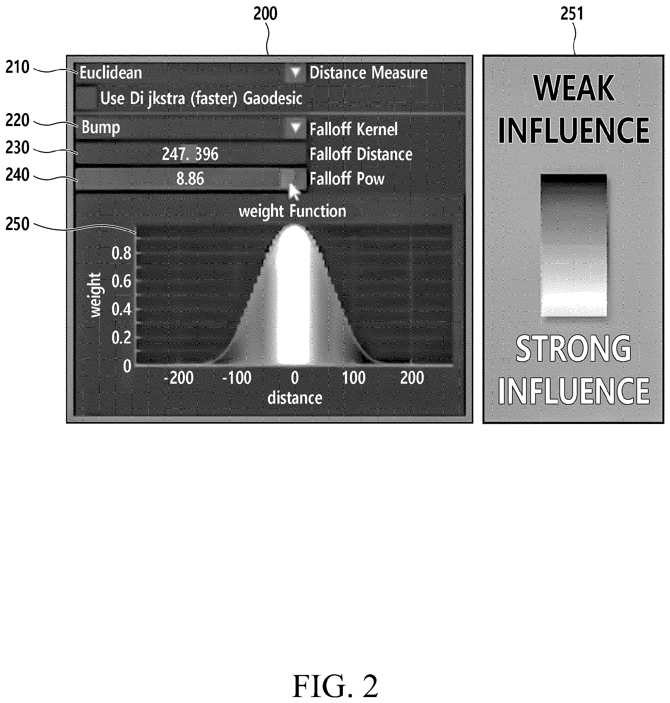

FIG. 2 is a diagram schematically illustrating an area adjustment interface according to an embodiment.

The description provided with reference to FIG. 1 may also apply to FIG. 2, and any repeated description related thereto may be omitted.

According to an embodiment, the electronic device 1300 may provide an area adjustment interface to a user interface when receiving one or more points or areas through the user interface.

The area adjustment interface 200 may include a Distance measure menu 210, a Falloff kernel menu 220, a Falloff distance menu 230, a Falloff Power menu 240, and a weight distribution 250. An influence 251 based on a weight distribution may be represented as a spectrum to visually illustrate the weight distribution 250.

The area adjustment interface 200 may provide a user with various options for adjusting weight for a specific part of clothing. The user may precisely set weight calculation method and distribution through the area adjustment interface 200.

The Distance measure menu 210 is a menu for selecting a distance measurement method to be used when calculating a weight. For example, the user may select Euclidean distance (or straight) or geodesic distance (or intrinsic, geodetic, surface, etc.).

The Falloff kernel (or Falloff shape) menu 220 is a menu for selecting a function determining the shape of the weight distribution. The user may select functions, such as a linear function, a hat function, a bump function, or a sinusoidal function. The hat function may provide a conical weight distribution, and the bump function may provide a Gaussian weight distribution. The sinusoid function may provide a weight distribution having a periodic pattern.

The Falloff distance menu 230 is a menu for setting the range of a weight distribution. The user may set a maximum distance from one or more selected points (or areas) to be weighted. For example, the weight may be applied within a specific area, such as a distance from a sleeve end to a shoulder.

The Falloff Power menu 240 is a menu for adjusting the strength of a weight distribution. The user may set a rate of decrease of the weight distribution. A weight with a high value may decrease rapidly while a weight with a low value may decrease gradually.

The weight distribution 250 may visually display the distribution of weights calculated with a selected Falloff kernel, Falloff distance, or Falloff power settings. The user may monitor in real time how set values influence the weight distribution.

The influence 251 may serve as a description of the weight distribution 250. It may visually represent a transition in influence from low to high weight.

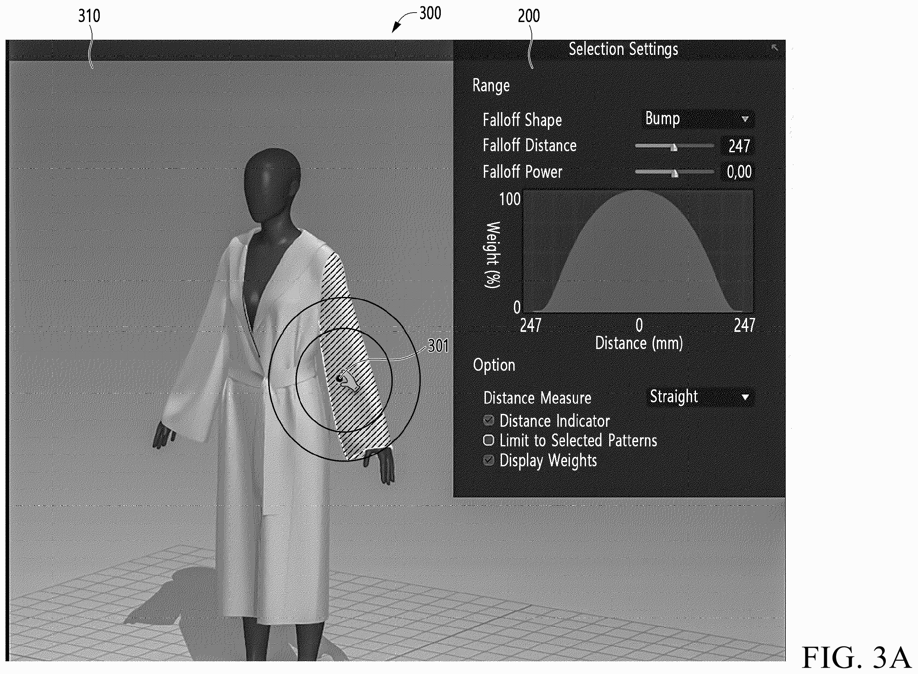

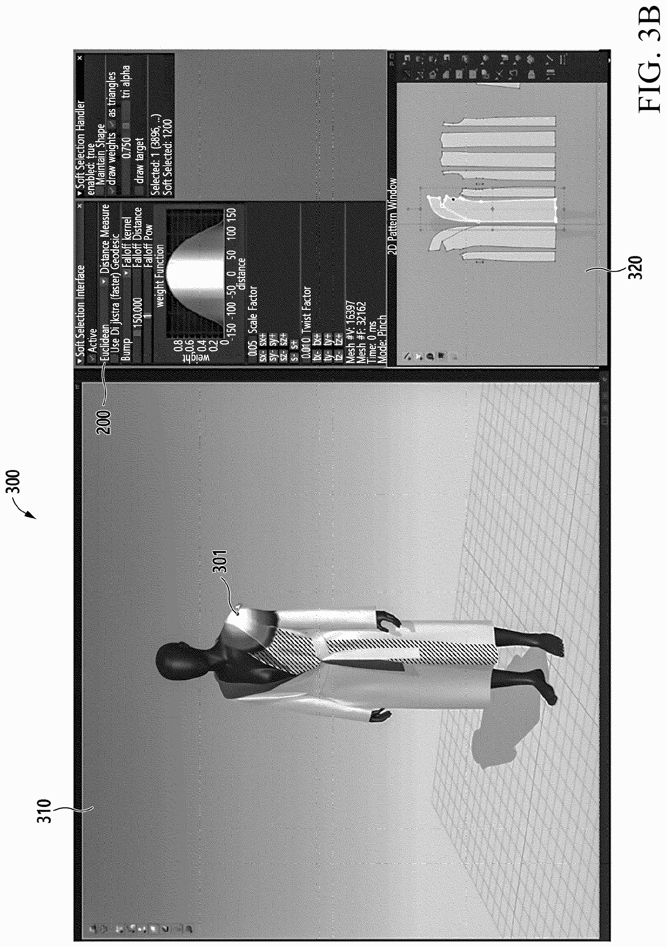

FIGS. 3A and 3B are diagrams, each schematically illustrating an activated state of soft selection according to an embodiment.

The description provided with reference to FIGS. 1 and 2 may also apply to FIGS. 3A and 3B, and any repeated description related thereto may be omitted.

Referring to FIGS. 3A and 3B, a user interface 300 may be an interface that provides various tools and settings that allow a user to select and modify a specific part of clothing. The user interface 300 may include a 3D modeling area 310, a 2D pattern area 320, and an area adjustment interface 200.

A soft selection activation area 301 may be one or more activation areas within a preset distance from one or more selected points or areas.

The soft selection activation area 301 may visually display weights of the one or more activation areas and allow the user to clearly recognize an area to be modified. The soft selection activation area 301 may be visually indicated on a specific part of clothing using a color or gradient, with the degree of influence represented by the intensity or variation of the color or gradient. For example, when the soft selection activation area 301 from a shoulder area to a chest area is selected, the soft selection activation area 301 may be naturally deformed based on the user's deformation and weight.

Depending on the settings of the user interface 300, the user may visually check the weight in the soft selection activation area 301 by clicking. An initial state of the soft selection activation area 301 may be a state where weight painting is not performed as shown in FIG. 3A, and a state where the weight painting is performed may be displayed by the user's clicking as shown in FIG. 3B. On the other hand, when the weight painting is set to be displayed continuously, the weight painting of the soft selection activation area 301 may be displayed continuously while the user's cursor is hovering over the clothing.

The 3D modeling area 310 may be an area where clothing and a user-selected avatar are displayed in 3D. The user may select a specific part of the clothing in the 3D modeling area 310 and deform it in real time. As described above, the area adjustment interface 200 may provide various menus for adjusting the weight of the soft selection activation area 301. The soft selection activation area 301 may be a part that visually displays the weights of the one or more activation areas in a 3D model window.

The 2D pattern area 320 may be an area that displays a pattern of clothing displayed in the 3D modeling area 310 in 2D so that the user may edit or adjust the pattern. The user may check the soft selection activation area 301 in the 2D pattern area 320 and check a pattern that is being currently edited.

The 2D pattern area 320 may display the user's soft selection activation area 320 in the 3D modeling area 310 corresponding to a soft selection activation function. In addition, even when at least a part of the clothing displayed in the 3D modeling area 310 is layered, the electronic device 1300 may reflect the soft selection activation area 320 on individual patterns in the 2D pattern area 320 by using weights applied to layered patterns in the 3D modeling area 310 based on a matrix that maps the coordinates of the individual patterns in the 2D pattern area 320 and the coordinates of individual patterns in the 3D modeling area 310.

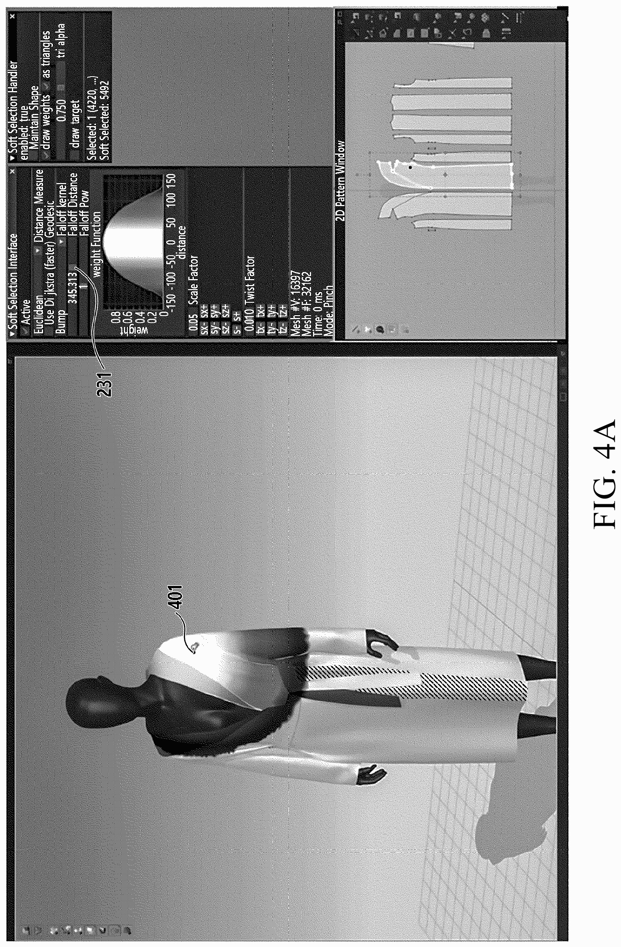

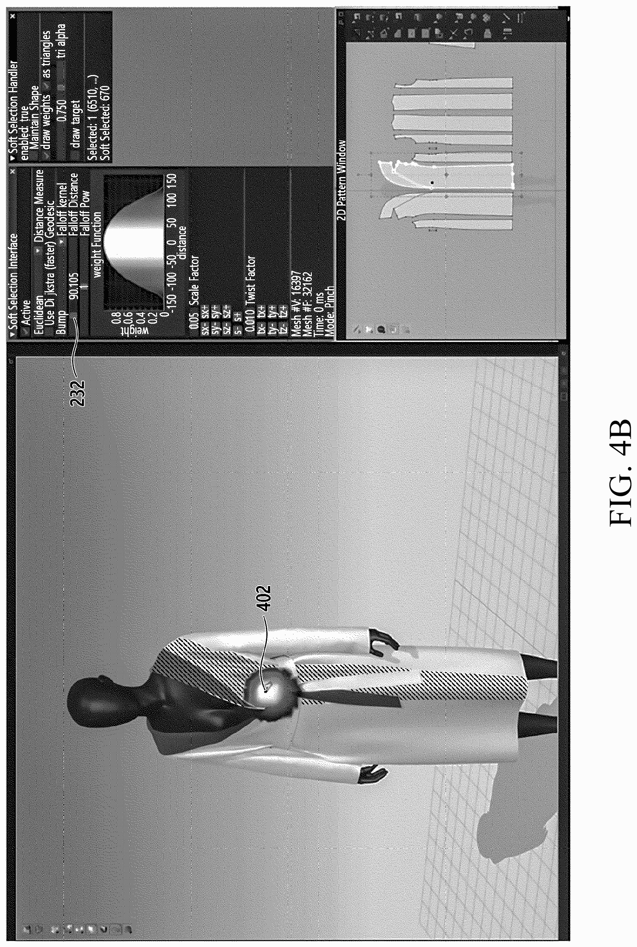

FIGS. 4A and 4B are diagrams, each schematically illustrating deformations in a soft selection activation area according to falloff distance adjustment, according to an embodiment.

The description provided with reference to FIGS. 1 to 3 may also apply to FIGS. 4A and 4B, and any repeated description related thereto may be omitted.

Referring to FIG. 4A, a soft selection activation area 301 may deform to increase the size of an area to be weighted according to the adjustment of a Falloff Distance in a Falloff Distance menu 230.

For example, when the user translates an adjustment bar of the Falloff Distance menu to the right to greatly change the Falloff Distance of the Falloff Distance menu 230 and adjusts it to a first Falloff Distance 231, the soft selection activation area 301 may be changed to a first Falloff Distance activation area 401.

Referring to FIG. 4B, the soft selection activation area 301 may deform to decrease the size of the area to be weighted according to the adjustment of the Falloff Distance in the Falloff Distance menu 230.

For example, when the user translates the adjustment bar of the Falloff Distance menu to the left to greatly change the Falloff Distance of the Falloff Distance menu 230 and adjusts it to a second Falloff Distance 232, the soft selection activation area 301 may be changed to a second Falloff Distance activation area 402.

The Falloff Distance may determine a range over which weights in one or more activation areas decrease and influence the size and shape of the soft selection activation area 301. When the Falloff Distance is set to be great, like the first Falloff Distance 231, a weight may decrease over a wider range, and the soft selection activation area 301 may deform into a wider shape. Conversely, when the Falloff Distance is set to be small, like the second Falloff Distance 232, a weight is applied to a narrower range, and the soft selection activation area 301 may deform into a smaller shape.

The user may adjust the size and shape of the soft selection activation area 301 through the Falloff Distance menu 230 to apply a weight to a desired part with desired intensity.

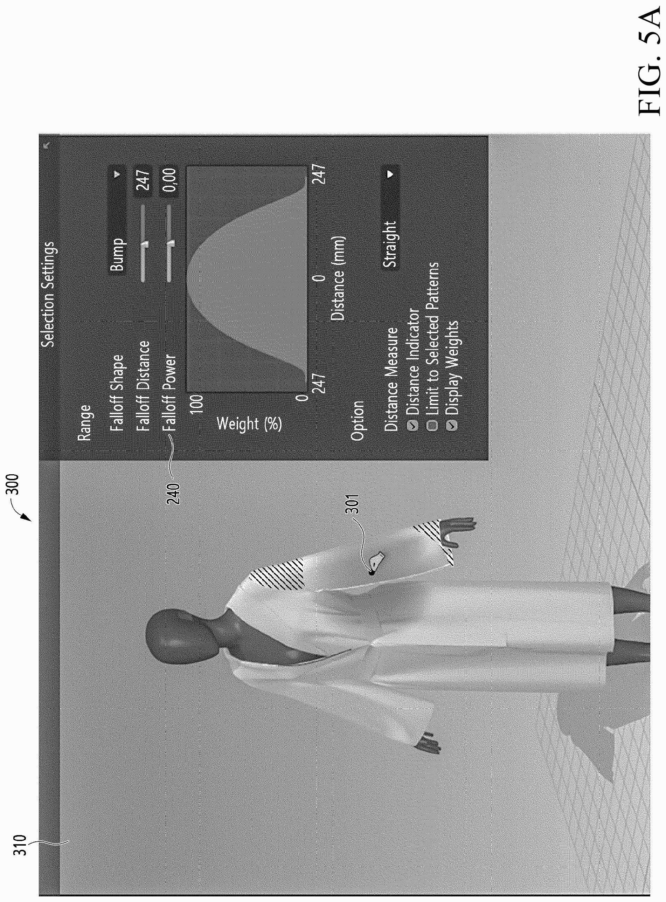

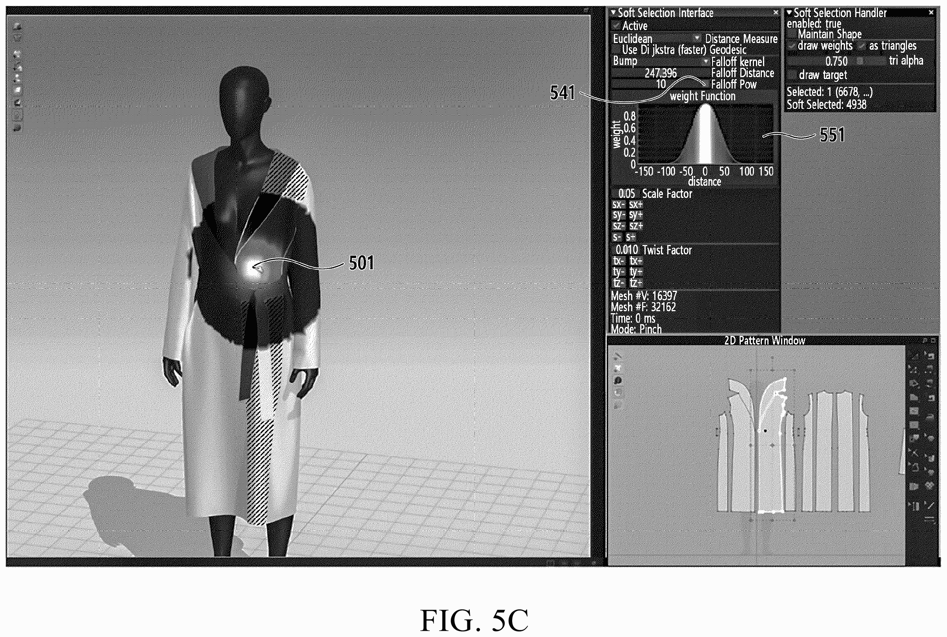

FIGS. 5A to 5E are diagrams, each schematically illustrating transformation of soft selection activation area according to falloff power adjustment, according to an embodiment.

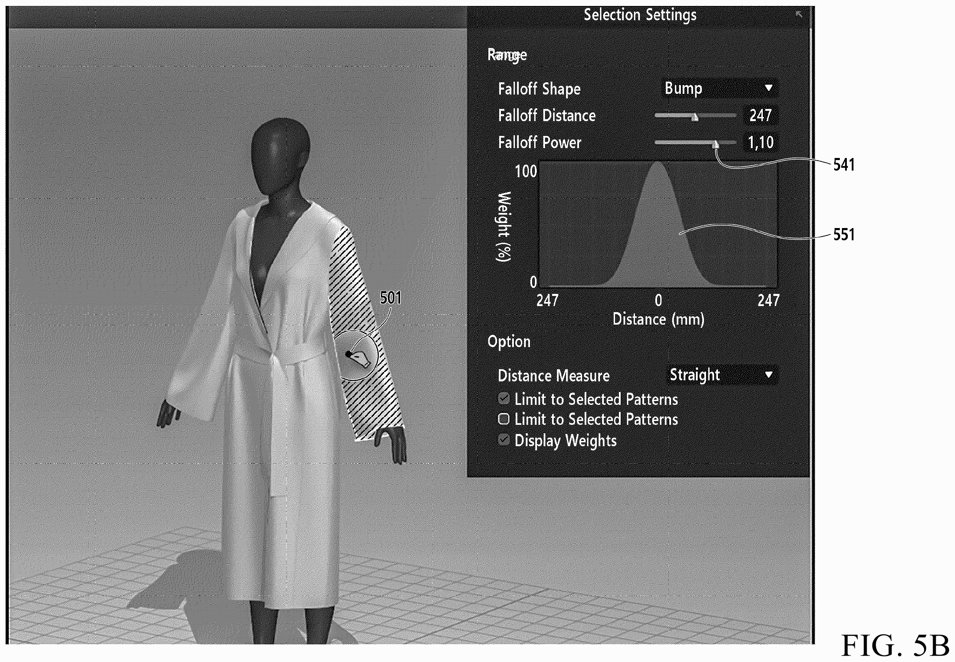

The description provided with reference to FIGS. 1 to 4B may also apply to FIGS. 5A and 5B, and any repeated description related thereto may be omitted.

Referring to FIGS. 5A to 5C, a method for applying a weight to a soft selection activation area 301 may vary depending on the adjustment of Falloff Power in a Falloff Power menu 240. For example, when the user translates an adjustment bar to the right and sets the Falloff Power high in the Falloff Power menu 240, adjusting to a first Falloff Power 541, the soft selection activation area 301 may deform like a first Falloff Power activation area 501. A first Falloff Power weight distribution 551 may visually show how weights are distributed according to this setting.

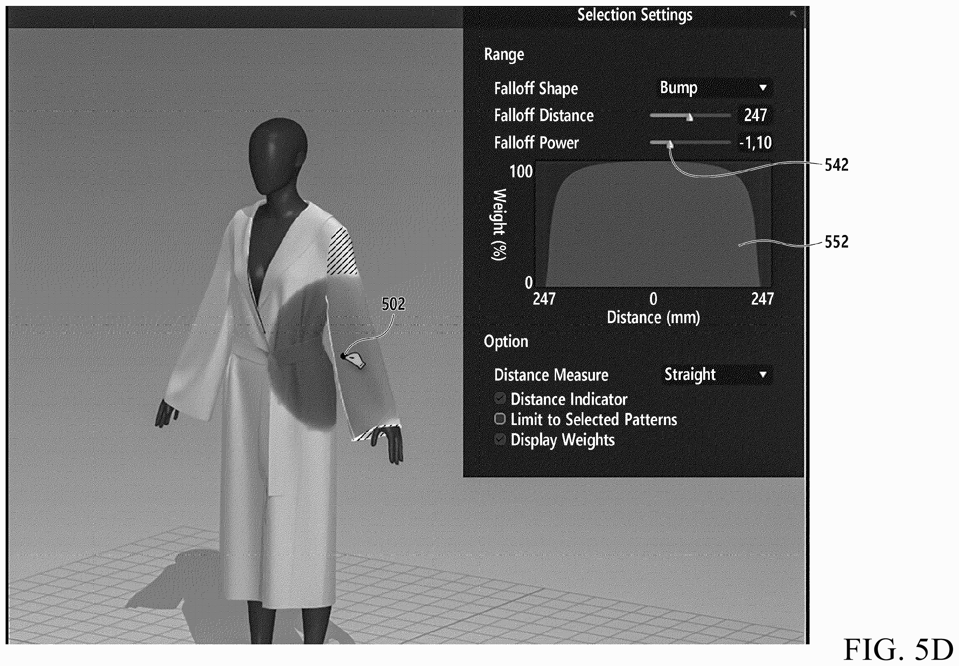

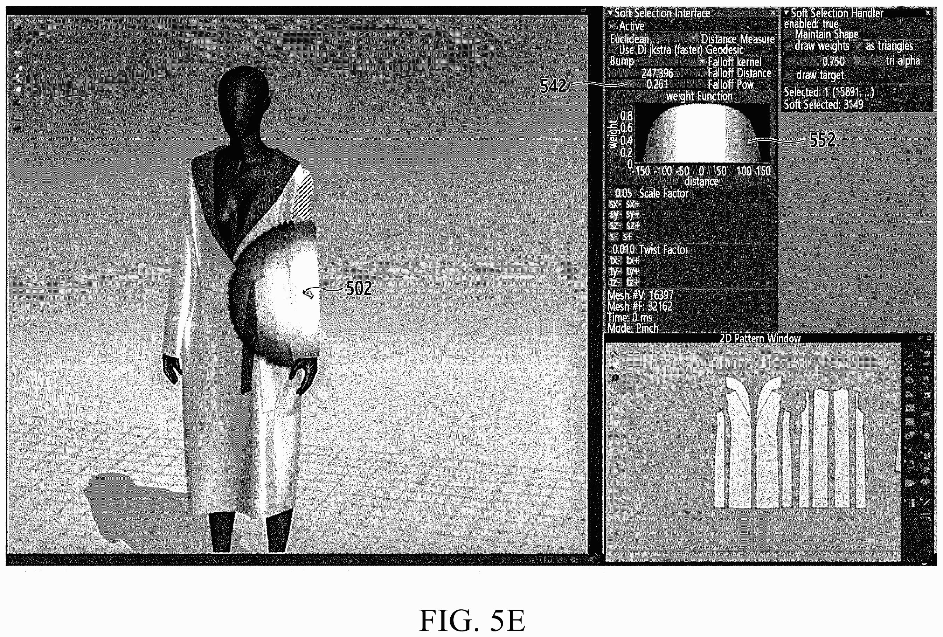

Referring to FIGS. 5A, 5D, and 5E, a method for applying a weight to the soft selection activation area 301 may vary depending on the adjustment of Falloff Power in a Falloff Power menu 240. For example, when the user translates an adjustment bar to the left and sets the Falloff Power low in the Falloff Power menu 240, adjusting to a second Falloff Power 542, the soft selection activation area 301 may deform like a second Falloff Power activation area 502. A second Falloff Power weight distribution 552 may visually show how weights are distributed according to this setting.

The Falloff Power determines the strength of a weight reduction in one or more activation areas, which may influence the weight distribution of soft selection activation areas. Setting to the first Falloff Power 541 may cause the weights to be modified to influence a narrower range within the same area. Setting to the second Falloff Power 542 may cause the weights to be modified to influence a wider range within the same area.

The user may adjust the weight distribution of the soft selection activation area 301 through the Falloff Power menu 340 to apply a weight to a desired part with desired intensity.

In the embodiments described, the Falloff Distance menu 230 and the Falloff Power menu 240 are shown in the form of adjustment bars for adjusting numerical values, but examples are not limited thereto and may alternatively be provided in other forms, such as a direct input of a desired value.

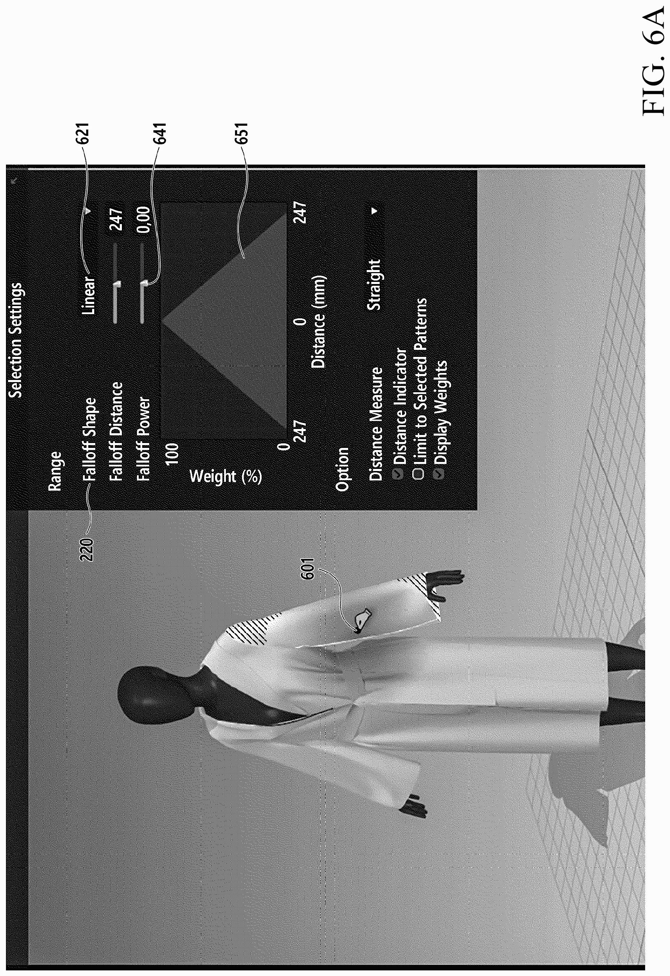

FIGS. 6A to 6E are diagrams, each schematically illustrating a weight distribution deformation according to adjustment of a falloff kernel menu, according to an embodiment.

The description provided with reference to FIGS. 1 to 5B may also apply to FIGS. 6A to 6E, and any repeated description related thereto may be omitted.

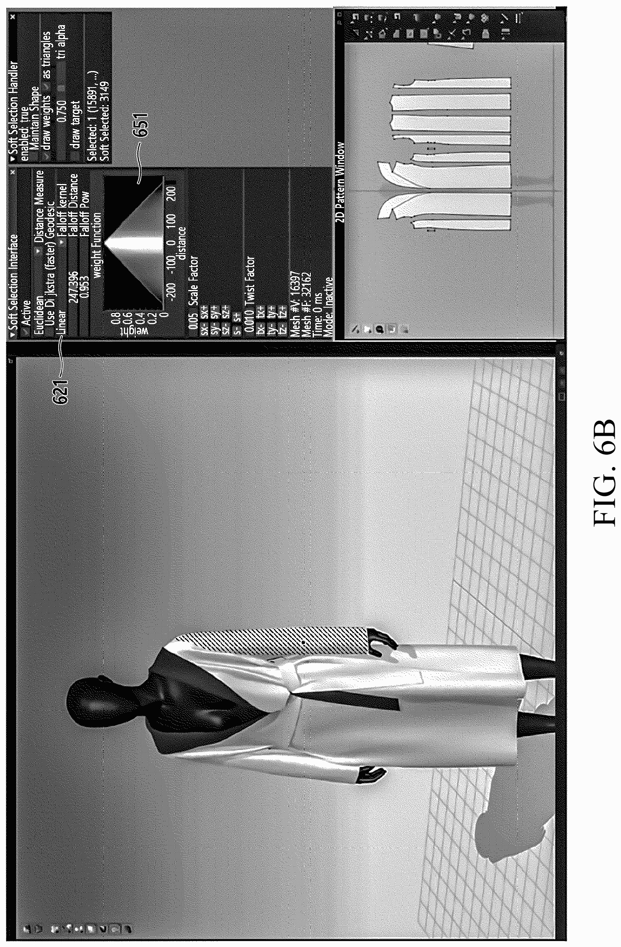

Referring to FIGS. 6A and 6B, when the user selects a linear function 621 from a Falloff Kernel (or Falloff Shape) menu 220, the weight distribution of a soft selection activation region 301 may deform into a first linear weight distribution 651. In this case, weights may have a distribution that linearly decreases depending on the distance from a selected point in a first linear Falloff Power 641. Accordingly, the soft selection activation region 301 may deform into a first linear activation area 601.

The area adjustment interface 200 may provide the user with various options for adjusting the weight distribution method through the Falloff Kernel menu 220. The available functions are not limited to the embodiments described.

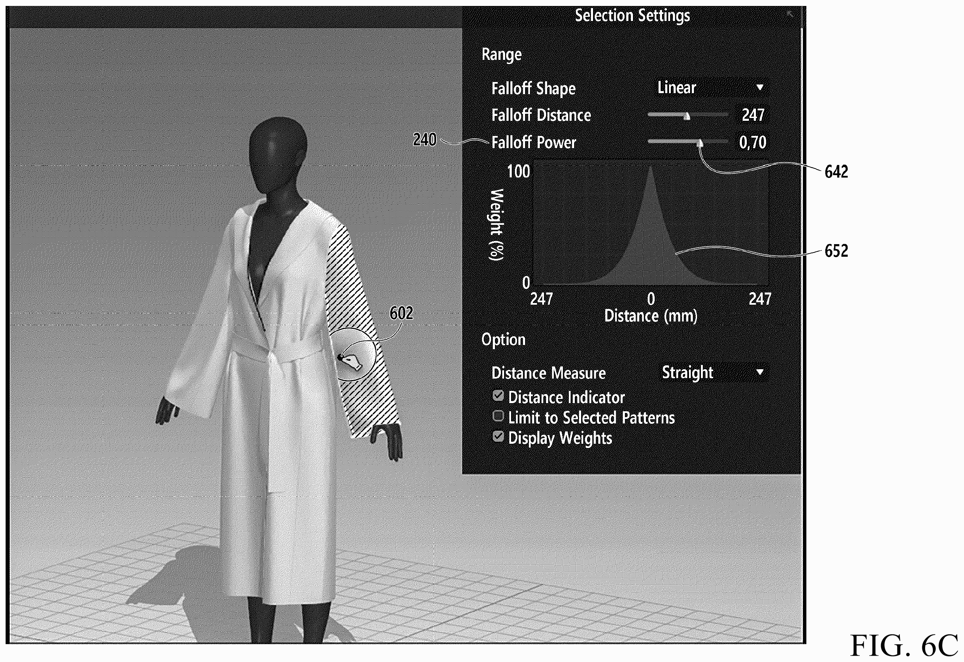

Referring to FIG. 6C, when the user changes a Falloff Power menu 240 to a second linear Falloff Power 642, the weight distribution of the first linear activation area 601 may deform into a second linear weight distribution 652. In this case, the weights vary depending on the value of the second linear Falloff Power 642 based on the distance from the selected point, and the first linear activation area 601 may deform into the second linear activation area 602.

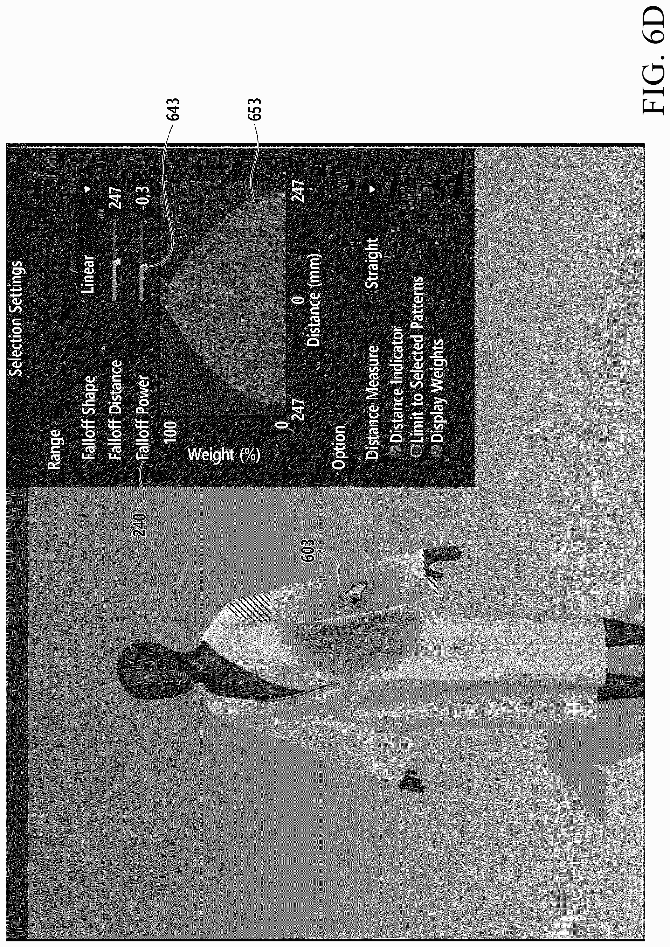

Referring to FIG. 6D, when the user changes the Falloff Power menu 240 to a third linear Falloff Power 643, the weight distribution of the second linear activation area 602 (or the first linear activation area 601) may deform into a third linear weight distribution 653. In this case, the weights vary depending on the value of the third linear Falloff Power 643 based on the distance from the selected point, and the second linear activation area 602 (or the first linear activation area 601) may deform into the third linear activation area 603.

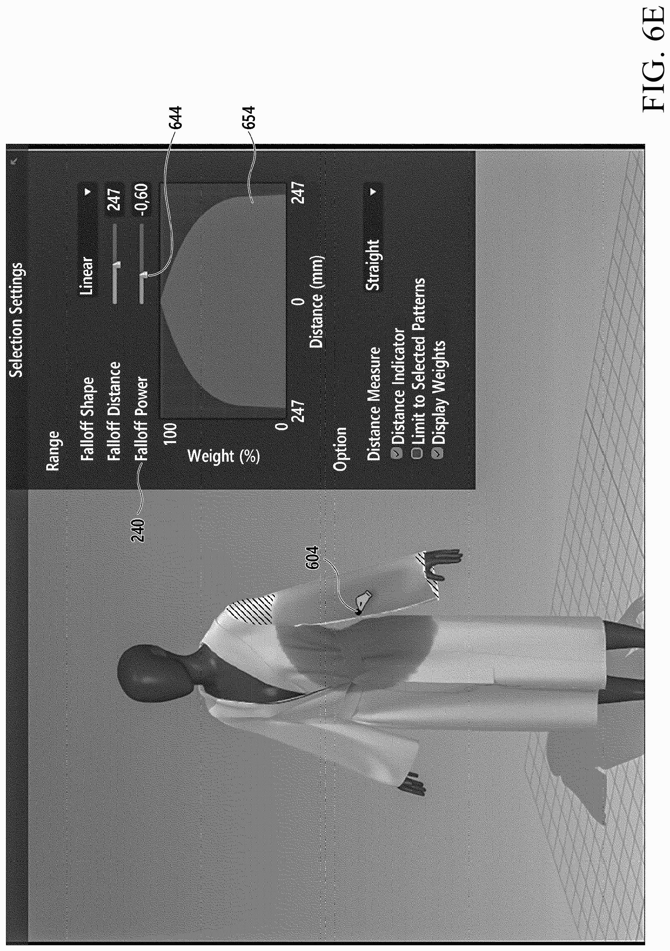

Referring to FIG. 6E, when the user changes the Falloff Power menu 240 to a fourth linear Falloff Power 644, the weight distribution of the third linear activation area 603 (or the first linear activation area 601 or the second linear activation area 602) may deform into a fourth linear weight distribution 654. In this case, the weights vary depending on the value of the fourth linear Falloff Power 644 based on the distance from the selected point, and the third linear activation area 603 (or the first linear activation area 601 or the second linear activation area 602) may deform into a fourth linear activation area 604.

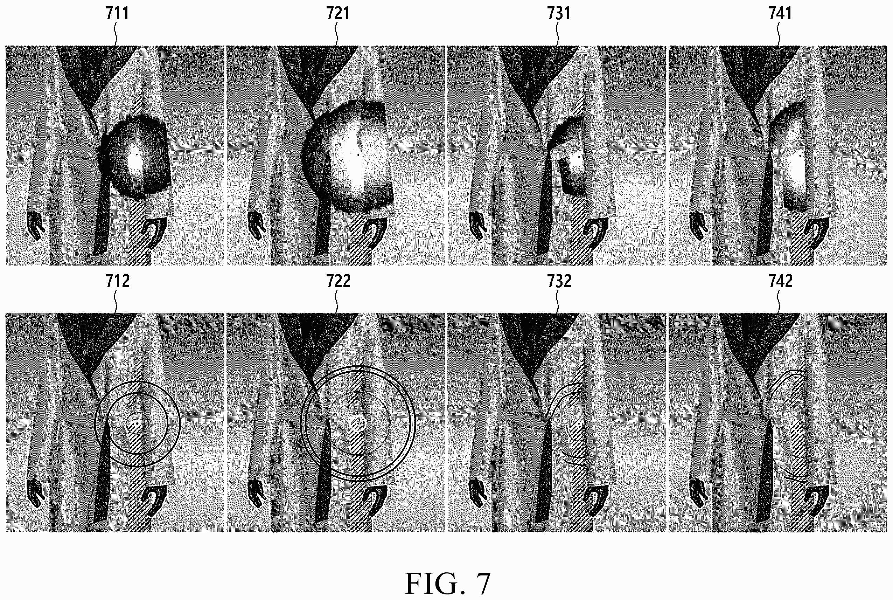

FIG. 7 is a diagram schematically illustrating Euclidean distance and geodesic distance according to an embodiment.

The description provided with reference to FIGS. 1 to 6 may also apply to FIG. 7, and any repeated description related thereto may be omitted.

FIG. 7 illustrates an example of a soft selection activation area 301 based on Euclidean distance and geodesic distance.

A Euclidean gradient brush initial state 711 may represent the soft selection activation area 301 based on Euclidean distance in the form of a gradient brush. The weights may decrease based on the distance from a user-selected point or area and be displayed as a gradient.

A Euclidean circle brush initial state 712 may represent the Euclidean gradient brush initial state 711 in the form of a circle brush and represent an initial state of the soft selection activation area 301 based on Euclidean distance in the form of a circle brush. An area within a certain radius from the selected point or area may be determined, and as the radius increases, the soft selection activation area 301 may become larger.

A Euclidean gradient brush extended state 721 may represent an expanded state of the soft selection activation area 301 based on Euclidean distance. The weights may decrease based on the distance from a user-selected point or area and be displayed as a gradient.

A Euclidean circle brush extended state 722 may represent the Euclidean gradient brush extended state 721 in the form of a circle brush and represent an extended state of the soft selection activation area 301 based on Euclidean distance in the form of a circle brush. An area within a certain radius from the user-selected point or area may be determined, and as the radius increases, the soft selection activation area 301 may become larger.

A geodesic gradient brush initial state 731 may represent an initial state of the soft selection activation area 301 based on geodesic distance in the form of a gradient brush. The electronic device 1300 may calculate a distance along a mesh surface of clothing on the user interface 300, display a soft selection activation area 301 corresponding to a user-selected point or area, and indicate changes in weights using a gradient.

A geodesic circle brush initial state 732 may represent the geodesic gradient brush initial state 731 in the form of a circle brush and represent an initial state of the soft selection activation area 301 based on geodesic distance in the form of a circle brush. The electronic device 1300 may calculate a distance along the mesh surface of the clothing on the user interface 300 and represent the soft selection activation area 301 corresponding to a user-selected point or area as a circle brush.

A geodesic gradient brush extended state 741 may represent an expanded state of the soft selection activation area 301 based on geodesic distance. The electronic device 1300 may calculate a distance along a mesh surface of clothing on the user interface 300, display a soft selection activation area 301 corresponding to a user-selected point or area, and indicate changes in weights using a gradient.

A geodesic circle brush extended state 742 may represent the geodesic gradient brush extended state 741 in the form of a circle brush and represent an extended state of the soft selection activation area 301 based on geodesic distance in the form of a circle brush. The electronic device 1300 may calculate a distance along the mesh surface of the clothing on the user interface 300 and represent the soft selection activation area 301 corresponding to a user-selected point or area as a circle brush.

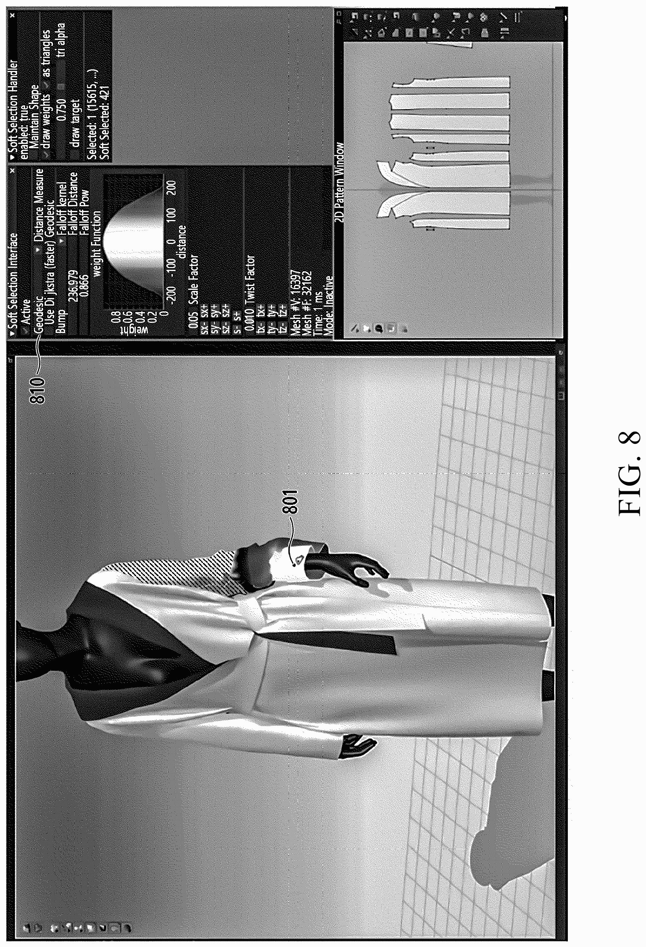

FIG. 8 is a diagram schematically illustrating geodesic distance-based soft selection according to an embodiment.

The description provided with reference to FIGS. 1 to 7 may also apply to FIG. 8, and any repeated description thereof is omitted.

When a user selects geodesic distance 810 from a Distance Measure menu 210 in an area adjustment interface 200 and selects a sleeve of clothing, the electronic device 1300 may recognize the selection and set a soft selection activation area 301 as a geodesic activation area 801. The electronic device 1300 may calculate a distance along a mesh surface of clothing from a selected point and represent an area corresponding to a user-selected point based on geodesic distance 810.

The electronic device 1300 may visually display one or more activation areas on a user interface 300 based on the geodesic distance 810 when the user selects a specific part of clothing. For example, when the user selects a sleeve part, the selected sleeve part may be displayed as the geodesic activation area 801.

The soft selection activation area 801 based on geodesic distance may calculate a distance along a mesh surface of clothing from a selected point and assign weights depending on the distance from the selected point. In this case, the electronic device 1300 may calculate a weight distribution according to a function of a Falloff Kernel menu 220 set by the user and adjust the deformation of one or more activation areas.

When the user selects a distance measure based on the geodesic distance 810, selects a sleeve part, and drags to deform the sleeve, the deformation of the sleeve part may be performed, and the mesh surface outside one or more activation areas may not be influenced by the user's drag.

The electronic device 1300 may perform deformations by considering the physical properties of one or more activation areas. For example, a smoothing function may be applied so that the sleeve part deforms smoothly, or a weight in a specific part may be limited to preserve the pattern or design of the clothing.

In addition, the electronic device 1300 may display the deformation results of one or more activation areas on the screen in real time. When the user selects and deforms a sleeve, the selected sleeve part may be displayed as the geodesic distance-based activation area 801, and the deformed state may be reflected in real time. By viewing the deformation in real time, the user may verify the deformation result and readily perform necessary adjustments.

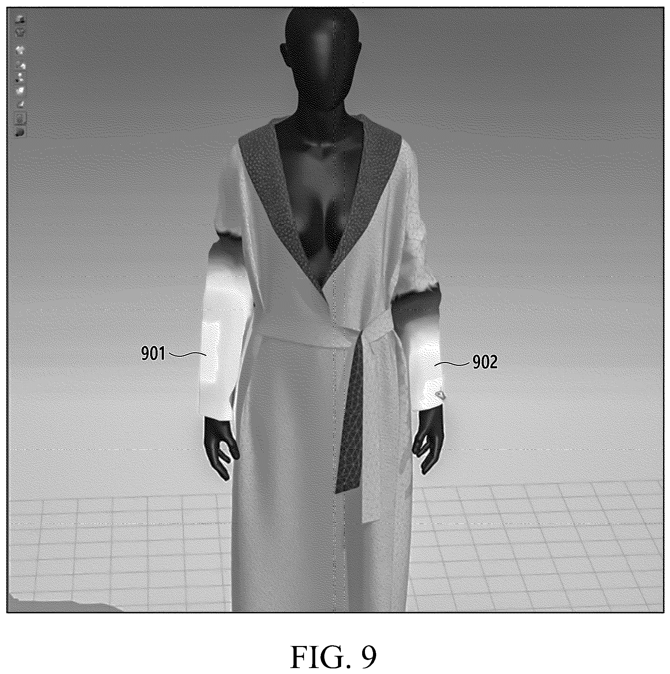

FIG. 9 is a diagram schematically illustrating multi-soft selection according to an embodiment.

The description provided with reference to FIGS. 1 to 8 may also apply to FIG. 9, and any repeated description thereof is omitted.

Referring to FIG. 9, a user may select multiple areas of clothing at once to perform multi-soft selection. The electronic device 1300 may generate soft selection activation areas 901 and 902 for each selected point or area when the user selects one or more points or areas through a user interface. In this case, each selected point or area may individually calculate a weight and be deformed. For example, when the user selects both sleeve parts simultaneously, soft selection activation areas 901 and 902 may be generated respectively for each sleeve part, thereby allowing the user to deform both sleeves at the same time.

If the multi-soft selection activation areas 901 and 902 are based on geodesic distance, a distance may be calculated along a mesh surface of clothing from one or more selected points or areas, and weights may be assigned depending on the distance from each selected point. In this case, the electronic device 1300 may calculate the weight distribution of each of one or more activation areas and control the deformation of each area.

The user may deform multiple parts of clothing simultaneously through the multi-soft selection function. For example, when the user selects both sleeve parts and drags to deform them, both sleeve parts may be deformed simultaneously.

The embodiments described may apply not only to selections of two parts but also to multiple areas. The user may select and deform multiple points or areas simultaneously, and the electronic device 1300 may individually generate soft selection activation areas for each selected point or area and perform the deformation.

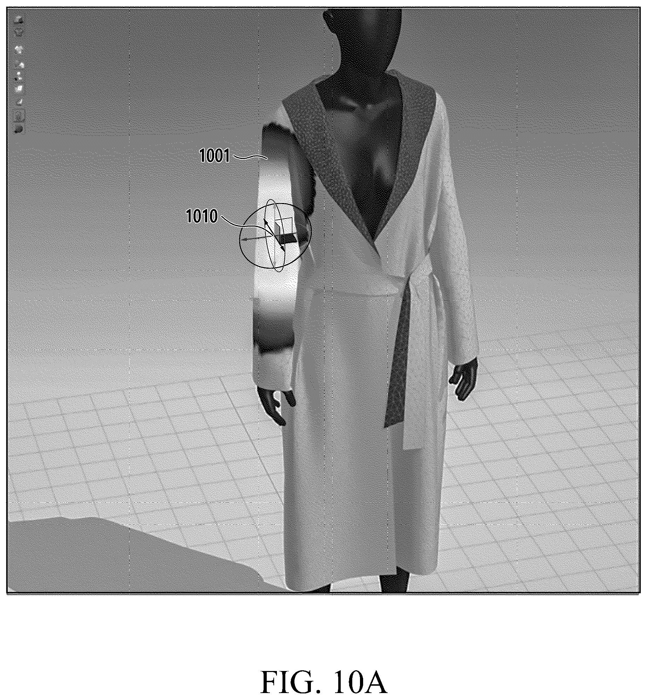

FIGS. 10A to 10C are diagrams, each illustrating operation of a gizmo interface according to an embodiment.

The description provided with reference to FIGS. 1 to 9 may also apply to FIGS. 10A to 6C, and any repeated description related thereto may be omitted.

FIGS. 10A to 10C each illustrate operation of a gizmo interface 1010. The electronic device 1300 may receive a user's gizmo input through a gizmo interface and perform simulations on geodesic distance-based arm soft selection activation area 1001, a waist strap soft selection activation area 1002, and a front torso soft selection activation area 1003.

The gizmo interface 1010 is a tool that assists the user in deforming selected areas, and the user may freely manipulate one or more activation areas through the gizmo interface.

The electronic device 1300 may receive an input from the user selecting a specific point or area through the user interface 300 and set a soft selection activation area for one or more selected points or areas. The user may use the gizmo interface 1010 to deform one or more selected points or areas, and the deformation may be performed based on geodesic distance.

FIG. 10A illustrates deformations performed by using the gizmo interface 1010 in the arm soft selection activation area 1001. A user may select an arm part and perform deformations, such as rotation, translation, and scaling, using the gizmo interface. For example, when the user inputs a folding-up translation of the arm part in the arm soft selection activation area 1001 through the gizmo interface 1010, the electronic device 1300 may receive the translation input and simulate the arm part folding up.

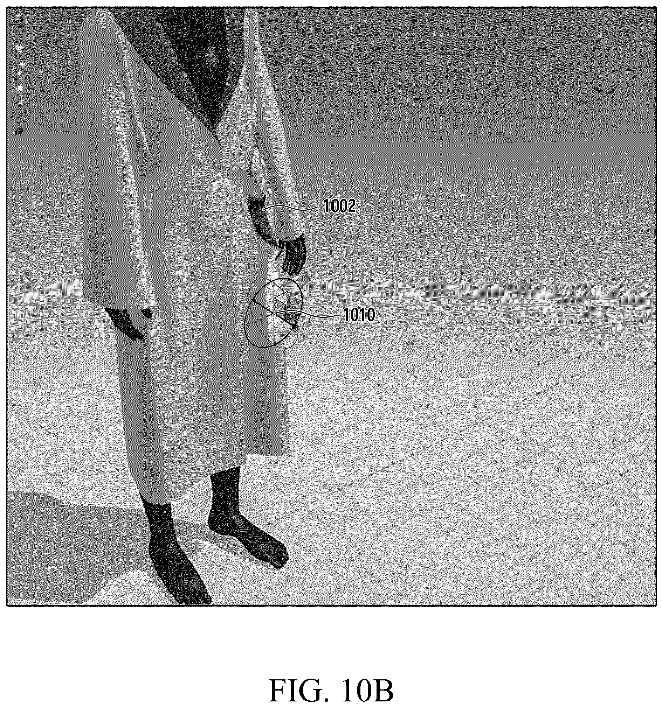

FIG. 10B illustrates deformations performed using the gizmo interface 1010 in the waist strap soft selection activation area 1002. A user may select a waist strap part and perform deformations, such as rotation, translation, and scaling, using a gizmo interface. For example, when the user inputs a rotation input of a waist strap through the gizmo interface 1010 in the waist strap soft selection activation area 1002, the electronic device 1300 may receive the rotation input and simulate a twisted waist strap.

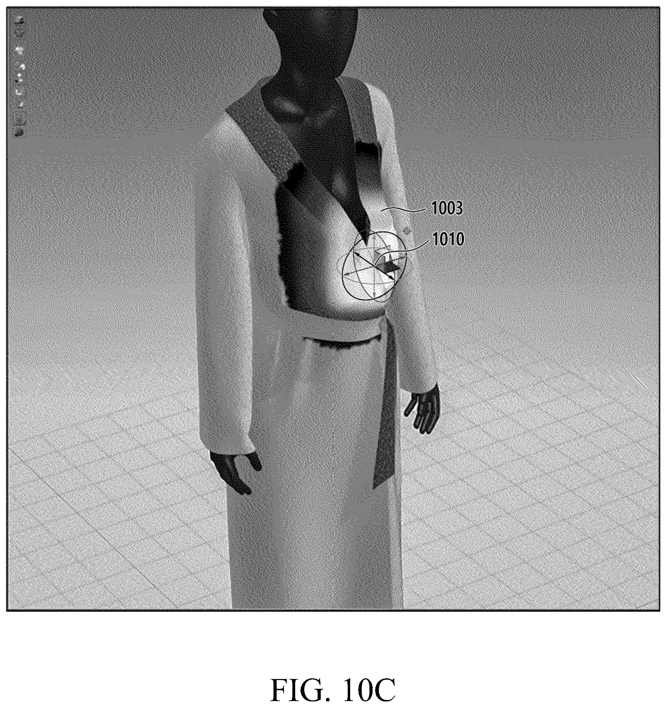

FIG. 10C illustrates deformations performed by using the gizmo interface 1010 in the front torso soft selection activation area 1003. A user may select a front torso part and perform deformations, such as rotation, translation, and scaling, using a gizmo interface. For example, when the user inputs an input for pulling the front of the torso through the gizmo interface 1010 in the front torso soft selection activation area 1003, the electronic device 1300 may receive the translation input and simulate the front of the torso translating along the gizmo interface 1010.

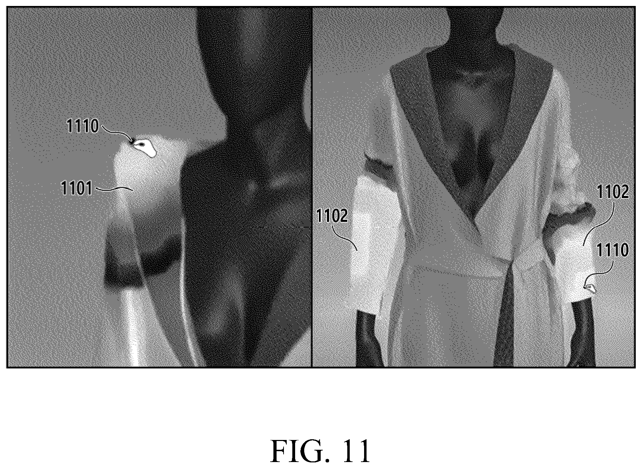

FIG. 11 is a diagram schematically illustrating a pinching interface according to an embodiment.

The description provided with reference to FIGS. 1 to 10C may also apply to FIG. 11, and any repeated description related thereto may be omitted.

Referring to FIG. 11, a shoulder soft selection activation area 1101 and sleeve soft selection activation areas 1102 may be deformed by a pinching interface 1110. The pinching interface 1110 is an interface that assists the user in deforming a selected area, and the user may freely manipulate one or more activation areas through pinching.

The user may select the shoulder soft selection activation area 1101 through the pinching interface 1110 and perform a pulling action. When the user selects a shoulder part and drags it by using the pinching interface 1110, the shoulder soft selection activation area 1101 may deform. The pinching interface 1110 may receive an input that allows the user to perform the action of picking up or pulling a specific point with two fingers, causing the electronic device 1300 to simulate the shoulder soft selection activation area 1101 as intended by the user.

A sleeve rolling up may be simulated with the user dragging the sleeve soft selection activation area 1102 by using the pinching interface 1110. When the user selects a sleeve part and drags it by using the pinching interface 1110, the sleeve soft selection activation areas 1102 deforms so that the sleeve may roll up naturally.

The electronic device 1300 may reflect the deformation of one or more activation areas received through the pinching interface 1110 in real time to the 3D modeling area 310. When the user selects a shoulder or sleeve part and deforms it using a pinching interface, the selected shoulder soft selection activation area 1101 and sleeve soft selection activation areas 1102 may be displayed on the screen in real time in a deformed state.

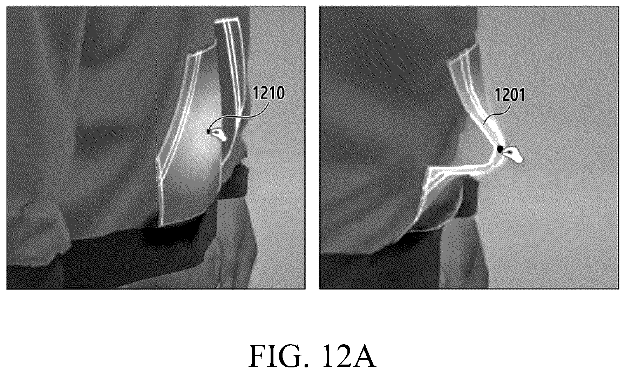

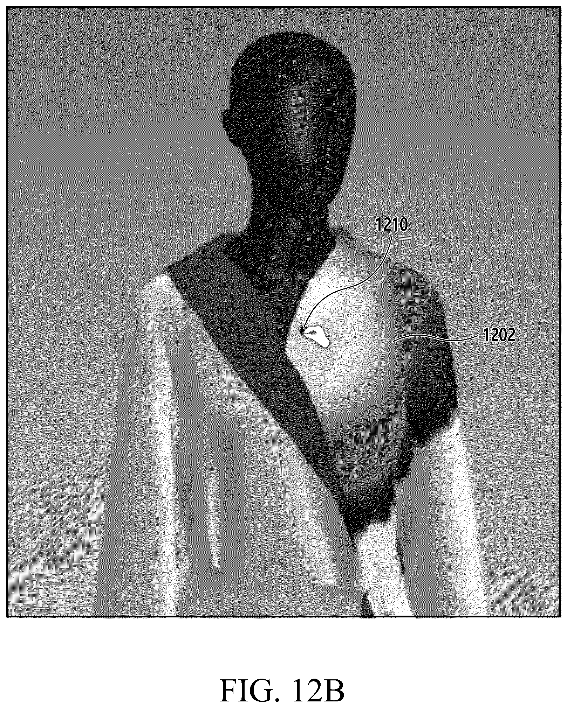

FIG. 12A and 12B are diagrams, each schematically illustrating a pinching interface according to an embodiment.

The description provided with reference to FIGS. 1 to 11 may also apply to FIGS. 12A and 12B, and any repeated description related thereto may be omitted.

Referring to FIGS. 12A and 12B, a user may use a pinching interface 1210 to deform and simulate a specific part of clothing. The electronic device 1300 may receive the user's pinching input and deform a pocket soft selection activation area 1201 and a collar soft selection activation area 1202. In this case, the electronic device 1300 may perform deformations and simulations by selecting a specific layer (or pattern) from the clothing in response to the user's pinching input.

Referring to FIG. 12A, the electronic device 1300 may perform simulations based on the user's pinching input received from a pinching interface 1210 in a pocket soft selection activation area 1201. When the user selects the front part of a pocket, which is a specific layer of a pocket part, and pulls it using the pinching interface 1210, the pocket soft selection activation area 1201 may be assigned to the front part of the pocket and be deformed based on the user's pinching input. The pinching interface 1210 may receive an input regarding the user's action of pulling or picking up the selected layer, which is the front of the pocket, with two fingers.

Referring to FIG. 12B, the electronic device 1300 may receive a pinching input through a pinching interface 1210 to specify a collar soft selection activation area 1202 and perform simulations. When the user selects a right collar, which is a specific layer of a collar part, and drags it using the pinching interface 1210, a collar soft selection activation area 1202 may deform and be simulated.

The electronic device 1300 may simulate the deformation of the selected layer in real time through the pinching interface 1210. When the user selects a specific layer of a pocket or collar part and deforms it using a pinching interface, the selected pocket soft selection activation area 1201 and collar soft selection activation area 1202 may be displayed in real time on the user interface 300 in a deformed state.

FIG. 13 is a block diagram illustrating an electronic device according to an embodiment.

Referring to FIG. 13, the electronic device 1300 may include a processor 1330, memory 1350, and an output device 1370 (e.g., a display). The processor 1330, the memory 1350, and the output device 1370 may be connected to one another via a communication bus 1305.

The output device 1370 may display clothing simulations provided by the processor 1330 together with a user interface.

The memory 1350 may store simulation results related to soft selection performed by the processor 1330. In addition, the memory 1050 may store various pieces of information generated in the process of the processor 1030 described above. In addition, the memory 1050 may store various pieces of data, programs, or the like. The memory 1050 may include a volatile memory or a non-volatile memory. The memory 1050 may include a massive storage medium, such as a hard disk, and store the various pieces of data.

In addition, the processor 1030 may perform at least one method described with reference to FIGS. 1 to 9 or an algorithm corresponding to the at least one method. The processor 1030 may be a data processing device implemented by hardware including a circuit having a physical structure to perform desired operations. For example, the desired operations may include code or instructions in a program. The processor 1030 may be implemented as, for example, a central processing unit (CPU), a graphics processing unit (GPU), or a neural network processing unit (NPU). The hardware-implemented electronic device 1000 may include, for example, a microprocessor, a CPU, a processor core, a multi-core processor, a multiprocessor, an application-specific integrated circuit (ASIC), and a field-programmable gate array (FPGA).

The processor 1030 may execute a program and control the electronic device 1000. The code of the program executed by the processor 1030 may be stored in the memory 1050.

The examples described herein may be implemented by using a hardware component, a software component, and/or a combination thereof. A processing device may be implemented using one or more general-purpose or special-purpose computers, such as, for example, a processor, a controller and an arithmetic logic unit (ALU), a digital signal processor (DSP), a microcomputer, a field-programmable gate array (FPGA), a programmable logic unit (PLU), a microprocessor, or any other device capable of responding to and executing instructions in a defined manner. The processing device may run an operating system (OS) and one or more software applications that run on the OS. The processing unit also may access, store, manipulate, process, and generate data in response to execution of the software. For purpose of simplicity, the description of a processing unit is used as singular; however, one skilled in the art will appreciate that a processing unit may include multiple processing elements and multiple types of processing elements. For example, the processing unit may include a plurality of processors, or a single processor and a single controller. In addition, different processing configurations are possible, such as parallel processors.

The software may include a computer program, a piece of code, an instruction, or some combination thereof, to independently or uniformly instruct or configure the processing device to operate as desired. Software and data may be embodied permanently or temporarily in any type of machine, component, physical or virtual equipment, computer storage medium or device, or in a propagated signal wave capable of providing instructions or data to or being interpreted by the processing device. The software also may be distributed over network-coupled computer systems so that the software is stored and executed in a distributed fashion. The software and data may be stored by one or more non-transitory computer-readable recording mediums.

The methods according to the above-described examples may be recorded in non-transitory computer-readable media including program instructions to implement various operations of the above-described examples. The media may also include, alone or in combination with the program instructions, data files, data structures, and the like. The program instructions recorded on the media may be those specially designed and constructed for the purposes of examples, or they may be of the kind well-known and available to those having skill in the computer software arts. Examples of non-transitory computer-readable media include magnetic media such as hard disks, floppy disks, and magnetic tape; optical media such as CD-ROM discs and/or DVDs; magneto-optical media such as optical discs; and hardware devices that are specially configured to store and perform program instructions, such as read-only memory (ROM), random-access memory (RAM), flash memory, and the like. Examples of program instructions include both machine code, such as produced by a compiler, and files containing higher-level code that may be executed by the computer using an interpreter.

The above-described devices may act as one or more software modules in order to perform the operations of the above-described examples, or vice versa.

As described above, although the examples have been described with reference to the limited drawings, a person skilled in the art may apply various technical modifications and variations based thereon. For example, suitable results may be achieved if the described techniques are performed in a different order and/or if components in a described system, architecture, device, or circuit are combined in a different manner and/or replaced or supplemented by other components or their equivalents.

Therefore, other implementations, other examples, and equivalents to the claims are also within the scope of the following claims.

**Claims**

1. A clothing simulation method comprising:

    receiving an input to select one or more points or areas of clothing through a user interface;
    determining one or more activation areas within a preset distance from the selected one or more points or areas;
    receiving motion or displacement based on the selected one or more points or areas;
    deforming the one or more activation areas corresponding to the received motion or displacement;
    interpolating a deformation corresponding to the motion or displacement depending on a distance from the selected one or more points or areas in an intermediate area within the one or more activation areas; and
    displaying the intermediate area in an interpolated state while the selected one or more points or areas are deformed, and a simulation area outside the one or more activation areas is being simulated.

2. The clothing simulation method of claim 1, wherein
   the one or more activation areas are areas that are influenced by motion or displacement of the selected one or more points or areas.

3. The clothing simulation method of claim 1, wherein

the motion comprises at least one of rotation, translation, scaling, or twisting.

4. The clothing simulation method of claim 1, wherein
the simulation area outside the one or more activation areas is an area that is minimally or not influenced by the motion or displacement of the selected one or more points or areas.

5. The clothing simulation method of claim 1, wherein

   the preset distance comprises Euclidean distance or geodesic distance, and
   the determining of the one or more activation areas comprises calculating a weight based on the Euclidean distance or the geodesic distance.

6. The clothing simulation method of claim 5, wherein
the calculating of the weight comprises calculating a weight distribution based on a function received through the user interface.

7. The clothing simulation method of claim 5, wherein
the determining of the one or more activation areas comprises performing smoothing or weight painting using a bitmap-based brush or stamp.

8. The clothing simulation method of claim 5, wherein
the determining of the one or more activation areas comprises post-processing the weight based on at least one of normalization, smoothing, or limiting a specific part of the garment, a mesh, or a pattern.

9. The clothing simulation method of claim 1, wherein
the receiving of the motion or displacement based on the selected one or more points or areas comprises sensing user input using a pinching interface, which is applied to a weight-applied area.

10. The clothing simulation method of claim 1, wherein
the receiving of the motion or displacement based on the selected one or more points or areas comprises sensing user input using a gizmo interface, which is applied to the one or more selected areas.

11. The clothing simulation method of claim 1, wherein
the interpolating comprises performing a weighted average on the degree of deformation of the intermediate area, based on a mesh deformation of the selected one or more points or areas.

12. The clothing simulation method of claim 11, wherein
the weight in the intermediate area is adjusted to a value between 0 and 1 based on a weight function.

13. A computer-readable storage medium storing a computer program that, when executed by a processor, causes the processor to perform the clothing simulation method of any one of claims 1.

14. An electronic device comprising:

   memory storing instructions,
   an output interface displaying a user interface; and
   one or more processors,
   wherein the instructions, when performed by the one or more processors, cause the electronic device to
   receive an input to select one or more points or areas of clothing through a user interface,
   determine one or more activation areas within a preset distance from the selected one or more points or areas,
   receive motion or displacement based on the selected one or more points or areas,
   deform the one or more activation areas corresponding to the received motion or displacement,
   interpolate a deformation corresponding to the motion or displacement depending on a distance from the selected one or more points or areas in an intermediate area within the one or more activation areas, and
   display the intermediate area in an interpolated state while the selected one or more points or areas are deformed and a simulation area outside the one or more activation areas is simulated.

```
                              ┌──────────────┐
                              │    Start     │
                              └──────────────┘
                                     │
                                     ▼                    ╱─110
   ┌────────────────────────────────────────────────────────────┐
   │        Receive selection input for one or more points or    │
   │            areas of clothing through user interface         │
   └────────────────────────────────────────────────────────────┘
                                     │
                                     ▼                    ╱─120
   ┌────────────────────────────────────────────────────────────┐
   │   Determine one or more activation areas within preset distance │
   │          from one or more selected points or areas          │
   └────────────────────────────────────────────────────────────┘
                                     │
                                     ▼                    ╱─130
   ┌────────────────────────────────────────────────────────────┐
   │         Receive movement or displacement based on one or more │
   │                  selected points or areas                   │
   └────────────────────────────────────────────────────────────┘
                                     │
                                     ▼                    ╱─140
   ┌────────────────────────────────────────────────────────────┐
   │        Deform one or more activation areas in response to    │
   │              received movement or displacement              │
   └────────────────────────────────────────────────────────────┘
                                     │
                                     ▼                    ╱─150
   ┌────────────────────────────────────────────────────────────┐
   │ Interpolate deformation corresponding to movement or displacement based on │
   │         distance from one or more selected points or areas in │
   │           intermediate area within one or more activation areas │
   └────────────────────────────────────────────────────────────┘
                                     │
                                     ▼                    ╱─160
   ┌────────────────────────────────────────────────────────────┐
   │  Display intermediate area in interpolated state while one or more │
   │            selected points or areas are in deformed state,  │
   │        and external simulation area is in simulated state   │
   └────────────────────────────────────────────────────────────┘
                                     │
                                     ▼
                              ┌──────────────┐
                              │     End      │
                              └──────────────┘
```

# FIG. 1

FIG. 2

FIG. 3A

EP 4 756 726 A1

FIG. 3B

EP 4 756 726 A1

FIG. 4A

FIG. 4B

EP 4 756 726 A1

FIG. 5A

FIG. 5B

EP 4 756 726 A1

FIG. 5C

FIG. 5D

FIG. 5E

FIG. 6A

EP 4 756 726 A1

EP 4 756 726 A1

FIG. 6B

FIG. 6C

FIG. 6D

EP 4 756 726 A1

FIG. 6E

FIG. 7

FIG. 8

FIG. 9

EP 4 756 726 A1

FIG. 10A

34

FIG. 10B

FIG. 10C

FIG. 11

FIG. 12A

FIG. 12B

1300

1305

Processor
1330

Output device
1370

Memory
1350

FIG. 13

# EP 4 756 726 A1

## INTERNATIONAL SEARCH REPORT

International application No.

**PCT/KR2024/011793**

### A. CLASSIFICATION OF SUBJECT MATTER

**G06T 19/20**(2011.01)i; **G06Q 30/06**(2012.01)i; **G06F 3/04845**(2022.01)i; **G06T 17/00**(2006.01)i; **G06T 15/04**(2011.01)i

According to International Patent Classification (IPC) or to both national classification and IPC

### B. FIELDS SEARCHED

Minimum documentation searched (classification system followed by classification symbols)

G06T 19/20(2011.01); G06F 3/0481(2013.01); G06F 3/0484(2013.01); G06T 13/40(2011.01); G06T 17/00(2006.01); G06T 19/00(2011.01); G06T 7/73(2017.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 의상 시뮬레이션(clothing simulation), 사용자 인터페이스(user interface), 활성화 영역(active region), 움직임(movement), 변위(displacement), 변형(deformation), 보간(interpolation), 유클리디안 거리(euclidean distance)

### C. DOCUMENTS CONSIDERED TO BE RELEVANT

| Category* | Citation of document, with indication, where appropriate, of the relevant passages | Relevant to claim No. |
|---|---|---|
| Y | KR 10-2022-0137527 A (CLO VIRTUAL FASHION INC.) 12 October 2022 (2022-10-12)<br>See paragraphs [0052], [0064], [0085], [0123] and [0126]; and claims 1, 7 and 10. | 1-14 |
| Y | KR 10-2017-0019917 A (FXGEAR INC.) 22 February 2017 (2017-02-22)<br>See paragraph [0049]; and claims 5-6. | 1-14 |
| Y | KR 10-2353776 B1 (STYLEME LIMITED) 19 January 2022 (2022-01-19)<br>See paragraphs [0007], [0068] and [0084]. | 5-8,11-12 |
| A | KR 10-2023-0074005 A (CLO VIRTUAL FASHION INC.) 26 May 2023 (2023-05-26)<br>See paragraphs [0003]-[0005]. | 1-14 |
| A | KR 10-1710521 B1 (FXGEAR INC.) 27 February 2017 (2017-02-27)<br>See paragraphs [0019]-[0024]. | 1-14 |

☐ Further documents are listed in the continuation of Box C.   ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **15 November 2024** | **15 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2024/011793**

| Patent document cited in search report | | | Publication date (day/month/year) | Patent family member(s) | | | Publication date (day/month/year) |
|---|---|---|---|---|---|---|---|
| KR | 10-2022-0137527 | A | 12 October 2022 | CN | 115917490 | A | 04 April 2023 |
| | | | | US | 2023-0102069 | A1 | 30 March 2023 |
| | | | | WO | 2022-211561 | A1 | 06 October 2022 |
| KR | 10-2017-0019917 | A | 22 February 2017 | KR | 10-1767144 | B1 | 11 August 2017 |
| KR | 10-2353776 | B1 | 19 January 2022 | CN | 109196561 | A | 11 January 2019 |
| | | | | CN | 109196561 | B | 28 October 2022 |
| | | | | KR | 10-2019-0118213 | A | 18 October 2019 |
| | | | | US | 2017-0161948 | A1 | 08 June 2017 |
| | | | | US | 9754410 | B2 | 05 September 2017 |
| | | | | WO | 2018-150220 | A1 | 23 August 2018 |
| KR | 10-2023-0074005 | A | 26 May 2023 | CN | 116710967 | A | 05 September 2023 |
| KR | 10-1710521 | B1 | 27 February 2017 | None | | | |

Form PCT/ISA/210 (patent family annex) (July 2022)